# FASCICULE DE BREVET EUROPEEN

(11) **EP 0 755 082 B1**
(45) Date de publication et mention de la délivrance du brevet: **07.11.2001**
(21) Numéro de dépôt: 96401557.2
(22) Date de dépôt: 15.07.1996
(51) Int. Cl.: H01L 31/12

(54) **Dispositif semiconducteur d'émission-réception notamment à 1,3 um et 1,5 um**
Sender/Empfänger-Halbleitervorrichtung insbesondere für 1,3um und 1,5um
Emitting/receiving semiconductor device particularly for 1.3um and 1.5um

(30) Priorité: 17.07.1995 FR 9508611
(43) Date de publication de la demande: 22.01.1997
(73) Titulaire: FRANCE TELECOM, 75015 Paris (FR)
(72) Inventeur: Nakajima, Hisao, 92220 Bagneux (FR); Charil, Josette, 92190 Meudon (FR)
(74) Mandataire: Signore, Robert

(56) Documents cités:
- US-A- 5 031 188
- PATENT ABSTRACTS OF JAPAN vol. 007, no. 033 (E-157), 9 Février 1983 & JP 57 184261 A (TATEISHI DENKI KK), 12 Novembre 1982,
- PATENT ABSTRACTS OF JAPAN vol. 018, no. 255 (E-1548), 16 Mai 1994 & JP 06 037299 A (NIPPON TELEGR & TELEPH CORP), 10 Février 1994,
- PATENT ABSTRACTS OF JAPAN vol. 011, no. 036 (E-477), 3 Février 1987 & JP 61 204987 A (NIPPON TELEGR & TELEPH CORP), 11 Septembre 1986,
- ELECTRONICS LETTERS, 24 OCT. 1991, UK, vol. 27, no. 22, ISSN 0013-5194, pages 2016-2018, XP002000380 HUI R ET AL: "DFB active filter/detector for multichannel FSK optical transmission"
- ELECTRONICS LETTERS, 26 OCT. 1989, UK, vol. 25, no. 22, ISSN 0013-5194, pages 1477-1479, XP002000381 CHARIL J ET AL: "Extremely low threshold operation of 1.5 mu m GaInAsP/InP buried ridge stripe lasers"
- IEEE JOURNAL OF QUANTUM ELECTRONICS, vol. 27, no. 3, 1 Mars 1991, pages 641-653, XP000227520 KOCH T L ET AL: "SEMICONDUCTOR PHOTONIC INTEGRATED CIRCUITS"
- ELECTRONICS LETTERS, vol. 27, no. 10, 9 Mai 1991, pages 809-810, XP000212340 WILLIAMS P J ET AL: "DESIGN AND FABRICATION OF MONOLITHICALLY INTEGRATED DFB LASER-WAVELENGTH DUPLEXER TRANSCEIVERS FOR TPON/BPON ACCESS LINKS"

## Description

### DOMAINE TECHNIQUE

La présente invention concerne un dispositif semiconducteur d'émission-réception.

Elle s'applique notamment aux télécommunications optiques.

En particulier, l'invention permet la réalisation des dispositifs suivants :
- un duplexeur à 1,3 µm - 1,5 µm pour transmission bidirectionnelle en modulation d'intensité, ce duplexeur permettant
   - soit, de façon simultanée ou alternative, une émission à 1,3 µm et une réception à 1,5 µm,
   - soit, de façon simultanée ou alternative, une émission à 1,5 µm et une réception à 1,3 um,
- un récepteur pour détecter de façon simultanée et démultiplexer des signaux à 1,3 µm et à 1,55 µm,
- un émetteur de signaux à 1,3 µm et à 1,5 µm multiplexés modulés en intensité ou codés par changement de fréquence,
- un récepteur pour détecter de façon simultanée des signaux à 1,3 µm et à 1,5 µm codés par changement de fréquence.

### ÉTAT DE LA TECHNIQUE ANTÉRIEURE

Les dispositifs d'émission-réception permettant simultanément l'émission et la réception de signaux optiques sont très importants pour les réseaux de distribution optique, notamment pour les extrémités de tels réseaux en lesquelles on place de tels dispositifs d'émission-réception.

On utilise communément une longueur d'onde pour l'émission et une autre longueur d'onde pour la réception.

On utilise par exemple les longueurs d'onde valant respectivement 1,3 µm et 1,5 µm.

On peut aussi utiliser une longueur d'onde légèrement inférieure à 1,3 µm tandis que l'autre longueur d'onde est légèrement supérieure à 1,3 µm.

Les dispositifs connus d'émission-réception comportent au moins un émetteur de lumière et une photodiode (détecteur de lumière), un diviseur optique ainsi que des moyens électroniques associés à ces composants.

L'intégration de tels composants sous la forme d'un composant unique " photonique " permet la simplification de la fabrication des dispositifs tout en diminuant leur coût.

En effet, le coût d'assemblage des composants contribue de façon importante au prix de revient de ces dispositifs d'émission-réception.

Deux types d'intégration peuvent être envisagés.

Un premier type d'intégration est fondé sur le principe de la réalisation de composants discrets (photodiode, émetteur laser et guide optique) sur un substrat.

A ce sujet, on se reportera au document (1) qui, comme les autres documents cités par la suite, est mentionné à la fin de la présente description.

Ce premier type d'intégration nécessite la mise en oeuvre d'une technologie complexe et très coûteuse.

En revanche, elle est généralement performante du fait que les composants utilisés peuvent être optimisés individuellement.

D'une manière générale, les dimensions du dispositif obtenu sont relativement grandes (de l'ordre de 3,5 mm x 0,6 mm) à cause d'un coupleur optique intégré que le dispositif comprend.

Un deuxième type d'intégration consiste en une intégration " photonique " réalisée à partir d'une structure laser, structure que l'on appelle souvent " structure en ligne " (" *in line structure* ") parce qu'un laser et une photodiode sont alignés suivant la ligne de propagation de signaux optiques.

A ce sujet, on se reportera au document (2) qui décrit des dispositifs d'émission-réception fondés sur une structure du type à réflecteur de Bragg distribué (" *distributed Bragg reflector* ").

La technique de l'intégration de composants photoniques sur un substrat est conceptuellement la plus simple.

Cependant, elle est très difficile à mettre en oeuvre et très coûteuse à cause de sa complexité.

Elle nécessite en effet la combinaison de plusieurs technologies différentes.

De plus, étant donné les dimensions non négligeables (quelques millimètres carrés) des dispositifs réalisés conformément à cette technique connue, le nombre de tels dispositifs réalisables sur un même substrat est faible.

Un dispositif à structure en ligne nécessite, quant à lui, des technologies homogènes pour la fabrication de toutes les parties de ce dispositif.

En conséquence, un tel dispositif est plus facile à fabriquer et a des coûts de fabrication moins élevés.

Cependant, les performances de ce dispositif ne sont pas très élevées.

Ceci résulte des compromis nécessaires en vue de simplifier la réalisation d'un tel dispositif.

De plus, ces performances sont déterminées par l'isolation tant électrique qu'optique.

En particulier, pour un dispositif émettant des signaux à 1,3 µm et détectant des signaux à 1,5 µm, la perturbation optique, que l'on appelle " diaphotie " et qui provient d'un laser dont la longueur d'onde vaut 1,3 µm, est déterminante pour la réception des signaux à 1,5 µm du fait que le récepteur de ces derniers signaux est également sensible à 1,3 µm.

Ce type d'inconvénient est inhérent à la structure en ligne du dispositif.

**JP-A-61 204987** décrit un dispositif d'émission-réception de lumière comprenant un premier élément émetteur-récepteur à la longueur d'onde L1, un deuxième élément émetteur-récepteur à la longueur d'onde L2 et un troisième élément émetteur-récepteur à la longueur d'onde L3 qui sont intégrés, dans cet ordre, sur un même substrat, avec L1<L2<L3.

### EXPOSÉ DE L'INVENTION

La présente invention a pour objet un dispositif semiconducteur d'émission-réception à deux longueurs d'onde différentes, ce dispositif ayant une structure facile à réaliser et de bonnes performances.

En particulier, l'invention concerne un dispositif d'émission-réception pour la transmission bidirectionnelle à 1,3 µm et 1,5 µm, ce dispositif étant capable d'émettre aussi bien à 1,3 µm qu'à 1,5 µm.

De façon précise, la présente invention a pour objet un dispositif semiconducteur d'émission-réception à deux longueurs d'onde λ1 et λ2, ce dispositif étant caractérisé en ce qu'il comprend un substrat semiconducteur sur lequel sont intégrés de façon monolithique :
- un premier composant semiconducteur ayant une couche active à la longueur d'onde λ1 ce premier composant étant apte à émettre une lumière de longueur d'onde λ1 ou à détecter cette lumière de longueur d'onde λ1 suivant que ce premier composant est polarisé de façon directe ou inverse,
- un deuxième composant semiconducteur ayant une couche active à la longueur d'onde λ2, ce deuxième composant étant apte à émettre une lumière de longueur d'onde λ2 ou à détecter cette lumière de longueur d'onde λ2 suivant que ce deuxième composant est polarisé de façon directe ou inverse, les couches actives respectives des premier et deuxième composants étant alignées suivant la ligne de propagation des lumières,
- au moins un composant semiconducteur intermédiaire qui sépare les premier et deuxième composants l'un de l'autre et qui est apte à absorber la lumière de longueur d'onde λ1 sans absorber la lumière de longueur d'onde λ2, lorsqu'il est polarisé de façon inverse, et .
- des moyens de polarisation de chaque composant intermédiaire de façon inverse.

La couche active du premier composant peut se prolonger dans chaque composant intermédiaire et chaque composant intermédiaire peut comprendre une couche active à la longueur d'onde λ1 qui est constituée par un prolongement de la couche active du premier composant.

Selon un premier mode de réalisation particulier du dispositif objet de l'invention, les premier et deuxième composants sont des composants à réseau de Bragg distribué.

Selon un deuxième mode de réalisation particulier, le premier composant est un composant à réseau de Bragg distribué et le deuxième composant est un composant à cavité de Fabry-Pérot.

Le dispositif objet de l'invention peut comprendre une pluralité de composants semiconducteurs intermédiaires.

Chacun des premier composant, deuxième composant et composant intermédiaire peut comprendre une couche une couche active à ruban, ce ruban étant bordé par des zones en un matériau semi-isolant.

Le premier composant, le deuxième composant et chaque composant intermédiaire peuvent comprendre des couches actives placées bout à bout, obtenues par une technique d'épitaxie sélective en surface ou une technique d'épitaxie localisée.

Chacun des premier composant, deuxième composant et composant intermédiaire peut comprendre une couche active à ruban, le ruban de chaque couche intermédiaire étant plus large que ceux des premier et deuxième composants.

La longueur d'onde λ1 peut être inférieure à la longueur d'onde λ2.

Selon un mode de réalisation préféré du dispositif objet de l'invention, la longueur d'onde λ1 vaut 1,3 µm et la longueur d'onde λ2 vaut 1,5 µm.

Il est possible de réaliser des dispositifs conformes à l'invention qui sont capables de
- recevoir des signaux simultanément à 1,3 µm et à 1,5 µm,
- émettre simultanément des signaux à 1,3 µm et à 1,5 µm,
- simultanément émettre des signaux à 1,3 µm et recevoir des signaux à 1,5 µm, et
- simultanément recevoir des signaux à 1,3 µm et émettre des signaux à 1,5 µm.

Ces dispositifs ont un coefficient de détection de 0,32 A/W à 1,3 µm et de 0,26 A/W à 1,5 µm.

Il est également possible d'obtenir une réduction de diaphonie de 10 dB entre les signaux à 1,3 µm et 1,5 µm.

En outre, ces dispositifs ont un faible encombrement (de l'ordre de 0,1 mmx0,4 mmx0,6 mm).

### BRÈVE DESCRIPTION DES DESSINS

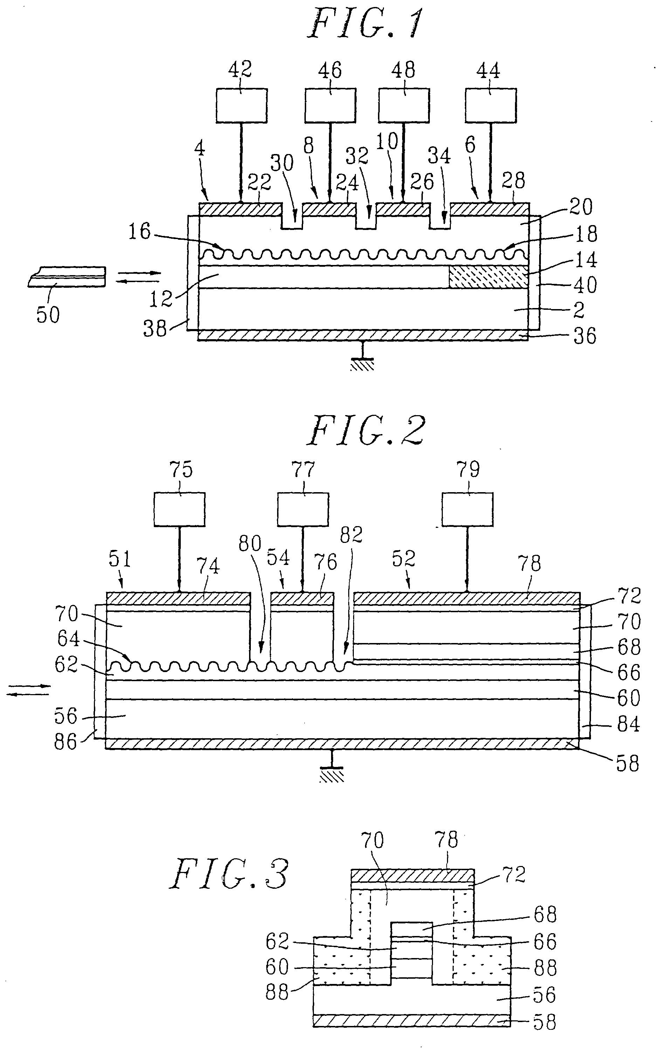

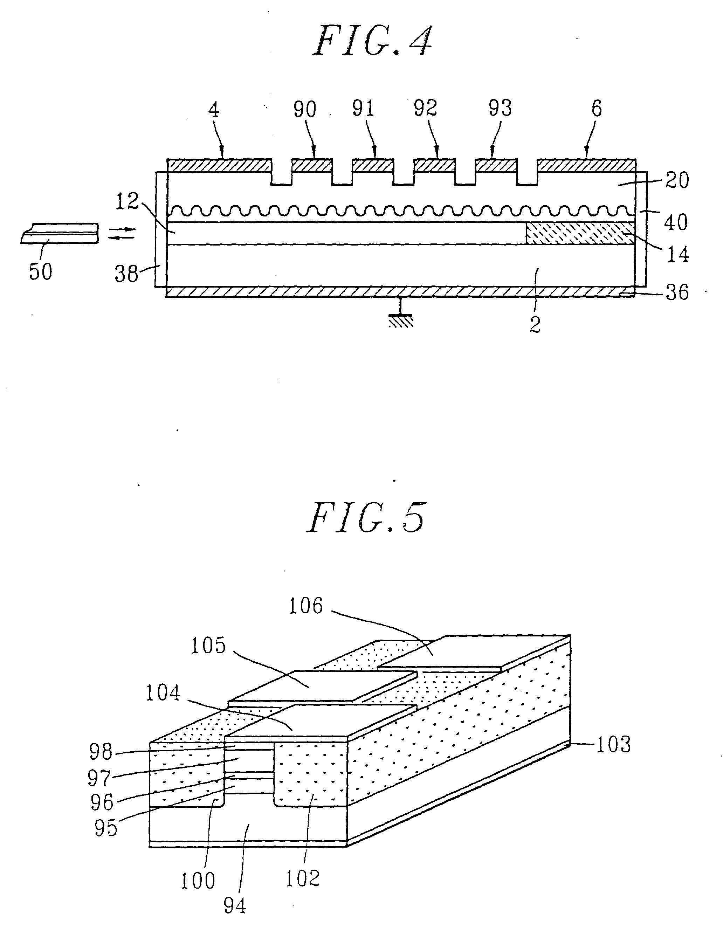

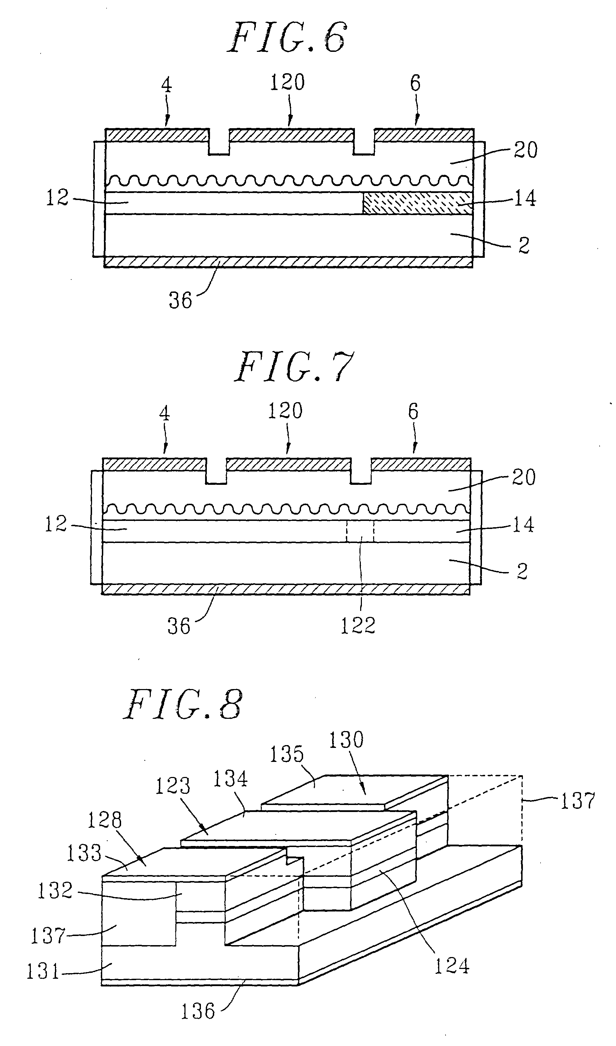

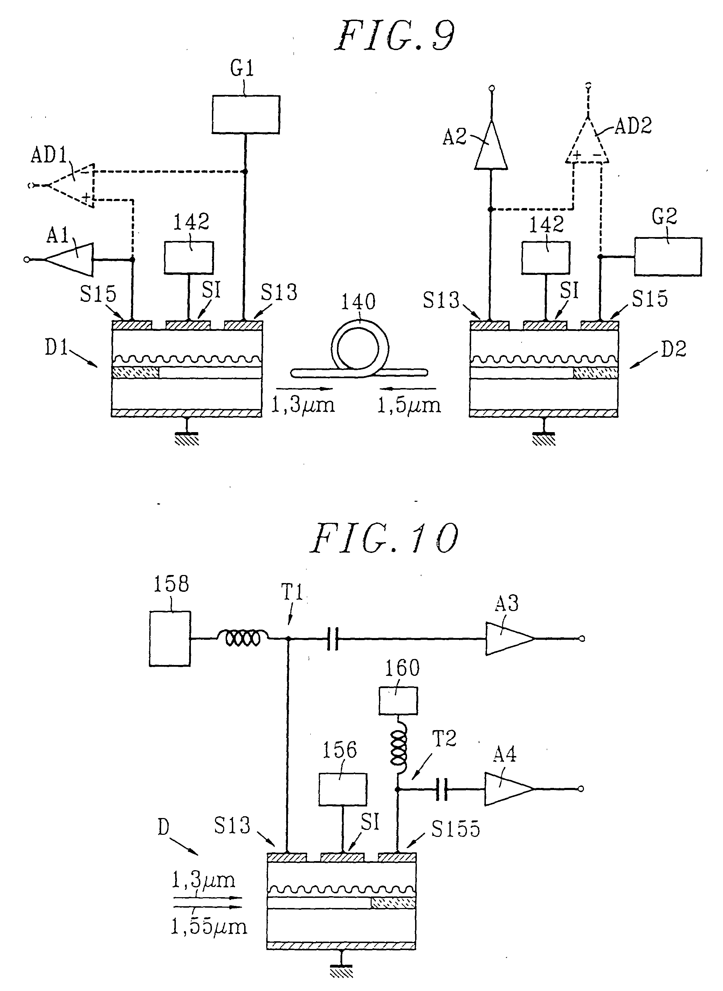

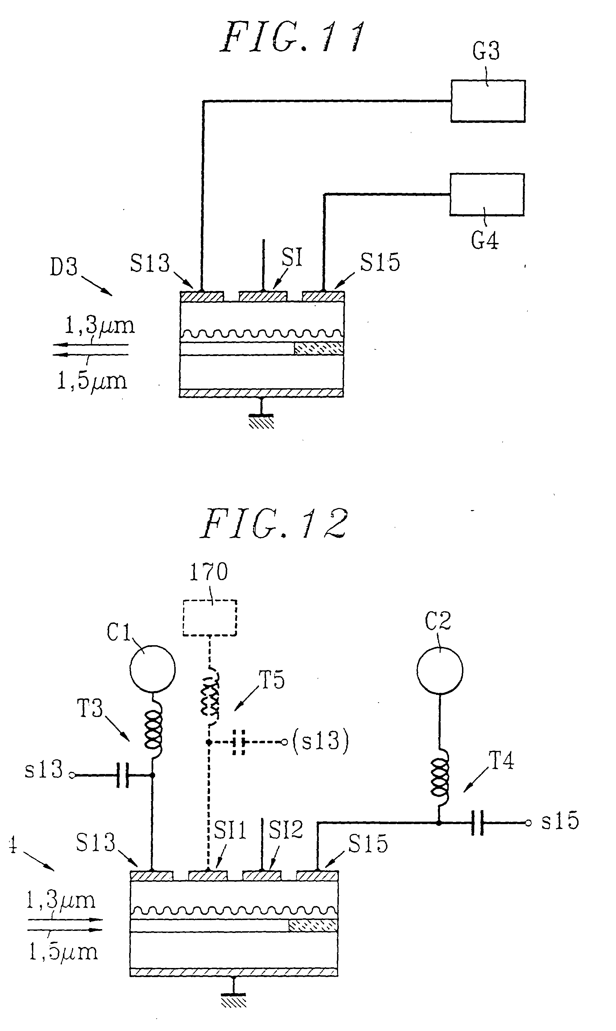

La présente invention sera mieux comprise à la lecture de la description d'exemples de réalisation donnés ci-après, à titre purement indicatif et nullement limitatif, en faisant référence aux dessins annexés sur lesquels :
∗ la figure 1 est une vue en coupe longitudinale schématique d'un premier mode de réalisation particulier du dispositif objet de l'invention, comprenant deux composants à contre-réaction distribuée (" *distributed feedback* "), séparés par deux composants intermédiaires,
∗ la figure 2 est une vue en coupe longitudinale schématique d'un autre mode de réalisation particulier comprenant un composant à contre-réaction distribuée, un autre composant à cavité de Fabry-Pérot et un composant intermédiaire,
∗ la figure 3 est une vue en coupe transversale du dispositif représenté sur la figure 2,
∗ la figure 4 est une vue en coupe longitudinale schématique d'un autre dispositif conforme à l'invention, comprenant une pluralité de composants intermédiaires,
∗ la figure 5 est une vue en perspective schématique d'un autre dispositif conforme à l'invention dans lequel un ruban (" *stripe* ") est bordé par des zones faites d'un matériau semi-isolant,
∗ la figure 6 est une vue en coupe longitudinale schématique d'un autre dispositif conforme à l'invention, dans lequel des couches actives sont placées bout à bout et réalisées par une technique d'épitaxie localisée,
∗ la figure 7 est une vue en coupe longitudinale schématique d'un autre dispositif conforme à l'invention, dans lequel des couches actives sont placées bout à bout et réalisées par une technique d'épitaxie sélective en surface,
∗ la figure 8 est une vue en perspective schématique et partielle d'un autre dispositif conforme à l'invention, dans lequel un composant intermédiaire comprend un ruban plus large que ceux des composants séparés par ce composant intermédiaire,
∗ la figure 9 illustre schématiquement une application de l'invention à la réalisation d'un duplexeur pour transmission bidirectionnelle en modulation d'intensité,
∗ la figure 10 illustre schématiquement une application de l'invention à la réalisation d'un récepteur pour détecter de façon simultanée des signaux à 1,3 µm et à 1,5 µm et démultiplexer ces signaux,
∗ la figure 11 illustre schématiquement une application de l'invention à la réalisation d'un émetteur de signaux optiques modulés en intensité ou codés par changement de fréquence, multiplexés à 1,3 µm et à 1,5 µm, et
∗ la figure 12 illustre schématiquement une application de l'invention à la réalisation d'un récepteur pour détecter de façon simultanée des signaux à 1,3 µm et à 1,5 µm codés par changement de fréquence.

### EXPOSÉ DÉTAILLÉ DE MODES DE RÉALISATION PARTICULIERS

Le dispositif conforme à l'invention, qui est schématiquement représenté sur la figure 1, comprend un substrat semiconducteur 2 sur lequel sont intégrés de façon monolithique :
- un premier composant semiconducteur 4,
- un deuxième composant semiconducteur 6, et
- deux composants intermédiaires 8 et 10 qui sont placés entre les composants 4 et 6.

Plus précisément, le dispositif de la figure 1 comprend, sur le substrat 2 par exemple InP dopé N, une couche active à la longueur d'onde 1,3 µm, référencée 12, qui est commune aux composants 4, 8 et 10, ainsi qu'une autre couche active à la longueur d'onde 1,5 µm, référencée 14, qui s'étend dans le composant 6 et prolonge la couche active 12 comme on le voit sur la figure 1.

Un réseau de Bragg 16, dont la longueur d'onde de Bragg vaut 1,3 µm, s'étend au-dessus de la couche active 12.

Ce réseau 16 est prolongé par un autre réseau de Bragg 18, dont la longueur d'onde de Bragg vaut 1,5 µm et qui s'étend quant à lui au-dessus de la couche active 14.

Ces réseaux 16 et 18 sont recouverts par une couche de confinement 20 par exemple en InP dopé P.

Cette couche de confinement 20 est recouverte par des couches conductrices 22, 24, 26 et 28 respectivement au niveau des composants 4, 8, 10 et 6.

Des zones 30, 32 et 34 sont gravées à partir de la face supérieure du dispositif de la figure 1 à travers ces couches conductrices et jusque dans la couche 20 pour assurer l'isolation électrique des couches 22, 24, 26 et 28 les unes par rapport aux autres, comme on le voit sur la figure 1.

La face inférieure du dispositif, c'est-à-dire la face inférieure du substrat 2, est recouverte d'une couche conductrice 32 mise à la masse.

La face-avant du dispositif, qui est située du côté de la couche 12, est recouverte d'une couche anti-reflet 38.

La face-arrière du dispositif, qui est située du côté de la couche 14, est quant à elle recouverte d'une couche de haute réflectivité 40.

Des moyens de polarisation 42, 44, 46 et 48 sont prévus pour polariser respectivement les couches conductrices 22, 28, 24 et 26.

On peut ainsi définir plusieurs sections dans le dispositif de la figure 1, à savoir :
- une section " active " à 1,3 µm qui correspond au composant 4,
- une section " active " à 1,5 µm qui correspond au composant 6, et
- deux sections absorbantes qui correspondent aux composants 8 et 10.

En effet, le composant 4 se comporte comme un laser à contre-réaction distribuée émettant à 1,3 µm, lorsqu'il est polarisé de façon directe, ou comme une photodiode détectant une lumière de longueur d'onde 1,3 µm, lorsqu'il est polarisé de façon inverse (ou nulle), par les moyens de polarisation correspondants 42.

De même, le composant 6 se comporte comme un laser à contre-réaction distribuée émettant à 1,5 µm, lorsqu'il est polarisé de façon directe, ou comme une photodiode détectant une lumière de longueur d'onde 1,5 µm, lorsqu'il est polarisé de façon inverse (ou nulle), par les moyens de polarisation correspondants 44.

Les moyens 46 et 48 sont, quant à eux, prévus pour polariser les composants 8 et 10 de façon inverse, de manière à absorber la lumière de longueur d'onde 1,3 µm se propageant dans la partie centrale du dispositif, tout en évitant l'absorption de la lumière de longueur d'onde 1,5 µm, et constituent donc des photodiodes détectant la lumière de longueur d'onde 1,3 µm.

Les sections absorbantes se comportent comme des filtres optiques qui bloquent les longueurs d'onde inférieures ou égales à 1,3 µm.

Les sections absorbantes permettent donc les séparations électrique et optique des sections actives à 1,3 µm et 1,5 µm.

Le dispositif de la figure 1 est ainsi capable d'émettre des signaux optiques à 1,3 µm et à 1,5 µm ou, inversement, de détecter de tels signaux optiques.

L'émission et la réception de tels signaux se fait par la face-avant du dispositif où se trouve la couche anti-reflet 38.

L'émission et la réception des signaux optiques s'effectuent donc à partir d'une seule entrée et, par conséquent, le dispositif ne nécessite qu'une seule fibre optique de liaison 50.

On précise que les sections absorbantes 8 et 10 sont déterminantes pour l'obtention d'une faible diaphonie dans le mode " émission à 1,3 µm - réception à 1,5 µm ".

La figure 2 est une vue schématique d'un autre dispositif conforme à l'invention, constituant un duplexeur 1,3 µm - 1,5 µm en ligne.

Ce dispositif est fondé sur une structure à ruban enterré (" *buried ridge structure* ").

A ce sujet, on se reportera au document (3).

Le dispositif de la figure 2 comprend une section active à 1,3 um référencée 51, une section active à 1,5 µm référencée 52 et, entre ces deux sections, une section absorbante 54.

Comme dans le cas de la figure 1, les sections 51 et 52 sont aptes à se comporter comme des lasers émettant respectivement à 1,3 µm et à 1,5 µm ou comme des photodiodes détectant des signaux optiques respectivement à 1,3 µm et 1,5 µm suivant la polarisation de ces sections.

La section absorbante 54 est, quant à elle, prévue pour absorber la lumière de longueur d'onde 1,3 µm.

Le dispositif de la figure 2 comprend plus précisément un substrat 56 en InP dopé N sur la face inférieure duquel se trouve une couche conductrice 58 mise à la masse.

La face supérieure du substrat 56 est recouverte par une couche 60 en InGaAsP dont la largeur de bande interdite correspond à 1,3 µm.

Cette couche 60 est recouverte d'une couche 62 en InGaAsP dont la largeur de bande interdite correspond à 1,18 µm.

Un réseau de diffraction 64, dont la longueur d'onde de Bragg vaut 1,3 µm, s'étend dans les sections 51 et 54, au-dessus de cette couche 62, comme on le voit sur la figure 2.

Dans la section 52, la couche 62 est recouverte par une mince couche 66 en InP.

Cette couche 66 est recouverte par une couche 68 en InGaAsP de largeur de bande interdite correspondant à 1,5 µm.

Une couche de confinement plane 70 en InP dopé P recouvre le réseau 64 et la couche 68.

Cette couche 70 est elle-même recouverte par une couche de contact 72.

Des électrodes 74, 76 et 78 recouvrent cette couche 72 respectivement dans les zones 51, 54 et 52 et sont reliées à des moyens 75, 77 et 79 de polarisation des sections correspondantes.

Des zones gravées 80 et 82 permettent la séparation électrique de ces électrodes 74, 76 et 78 et s'étendent jusqu'au réseau 64 à travers les couches 72 et 70, comme on le voit sur la figure 2.

A titre purement indicatif et nullement limitatif, les longueurs des sections 51, 54 et 52 valent respectivement 200 µm, 80 µm et 350 µm.

La face-arrière du dispositif de la figure 2, qui est située du côté de la couche 68, est recouverte d'une couche de haute réflectivité 84.

La face-avant du dispositif, qui est située du côté du réseau 64, est recouverte d'une couche anti-reflet 86.

Les signaux à détecter par le dispositif sont envoyés vers cette face-avant et les signaux optiques émis par le dispositif sortent de celui-ci par la couche 86.

La lumière issue de la couche 68 est couplée d'une façon évanescente au guide de lumière de 1,3 µm (couche 60) qui est transparent à 1,5 µm.

Le réseau 64 a un pas de 200 nm et il est est gravé dans la couche 62 et rétrodiffuse la lumière de longueur d'onde 1,3 µm.

De ce fait, lorsque la section 51 est polarisée de façon directe, elle fonctionne comme un laser à contre-réaction distribuée émettant à 1,3 µm.

Il est préférable que le coefficient de couplage du réseau 64 soit très élevé (supérieur à 200 cm⁻¹).

Cela permet de réaliser une structure à contre-réaction distribuée courte.

Lorsque la section absorbante 54 est polarisée de façon inverse, la lumière de longueur d'onde 1,3 µm y est très fortement absorbée.

La présence du réseau 64 dans cette section 54 renforce cet effet du fait de la réflexion de Bragg.

On précise que la séparation électrique des électrodes 74, 76 et 78 est réalisée par une combinaison d'une gravure sèche de type gravure par faisceau d'ions réactifs (" *reactive ion beam etching* ") et d'une attaque chimique.

Une gravure profonde jusqu'à la couche 62 permet d'obtenir une résistance électrique de séparation de 50 kλ.

On notera que la section 52 constitue un composant à cavité de Fabry-Pérot (laser de Fabry-Pérot lorsque la section 52 est polarisée en direct).

La figure 3 est une vue en coupe transversale schématique du dispositif de la figure 2 au niveau de la section 52.

On voit qu'on a réalisé une implantation de protons dans les deux zones 88 se trouvant de part et d'autre du ruban formé à partir de l'empilement des couches 60, 62, 66, 68.

Cela permet de diminuer le courant de fuite traversant les homojonctions latérales et la capacité parasite de la structure.

Une capacité de 4 pF/100 µm et un courant de fuite inférieur à 1 µA ont été obtenu à -1 V.

Avec le dispositif de la figure 2, on a obtenu un coefficient de détection (pente de la courbe des variations du photo-courant en fonction de la puissance optique d'entrée) de 0,32 A/W à 1,3 µm et de 0,26 A/W à 1,5 µm.

Des coefficients de détection supérieurs seraient obtenus en réduisant la réflectivité de la face-avant du dispositif de la figure 2.

On décrit dans ce qui suit des dispositifs plus évolués que ceux des figures 1 et 2 et permettant de réduire le courant de fuite en polarisation inverse, la capacité parasite du dispositif, la diaphonie et la diaphotie en haute fréquence, et de ce fait, d'améliorer la bande passante et la sensibilité de la détection.

Un premier dispositif amélioré est schématiquement représenté en coupe longitudinale sur la figure 4.

Ce dispositif de la figure 4 diffère simplement de celui de la figure 1 en ce qu'il comprend quatre sections absorbantes 90, 91, 92 et 93, au lieu des deux sections absorbantes 8 et 10 du dispositif de la figure 1.

La multiplication des sections absorbantes permet d'obtenir une diaphotie acceptable (de l'ordre de -40 dB) sans augmentation excessive de la longueur du dispositif.

Dans le cas de quatre sections absorbantes de 80 µm de long chacune, on obtient une diaphotie de -40 dB tout en limitant à 240 µm l'augmentation de la longueur.

Une telle solution est plus efficace que celle qui consisterait à augmenter la longueur d'une section absorbante unique.

Cela permet d'éviter une saturation de l'absorption à forte puissance optique, observable sur des photo-diodes.

En effet, les sections absorbantes sont des photo-diodes pour le laser émettant à 1,3 µm et un photo-courant de 2 mA a été observé à -2 V sur l'un des dispositifs décrits plus haut en faisant référence à la figure 2.

Dans le dispositif de la figure 4, la saturation de la section la plus proche du laser émettant à 1,3 µm permet d'éviter la saturation des sections absorbantes restantes et de maintenir correct le fonctionnement de ce dispositif.

Cette configuration à pluralité de sections absorbantes permet de ne pas augmenter considérablement les pertes de propagation entre la fibre optique 50 et la section active à 1,5 µm qui se trouve à l'extrémité opposée à l'entrée du dispositif de la figure 4.

Le dispositif amélioré, représenté sur la figure 5, utilise un matériau InP semi-isolant pour obtenir une isolation électrique suffisante des sections.

L'utilisation de ce matériau à la place de InP dopé P, notamment au voisinage latéral du ruban formé des couches 95, 96, 97, 98, permet de diminuer à la fois la capacité parasite des sections et le courant de fuite à travers les homojonctions latérales (en polarisation inverse et en polarisation directe).

Cette utilisation est illustrée par la figure 5 qui est une vue en coupe transversale d'un dispositif conforme à l'invention.

Sur cette figure 5
- la référence 94 représente un substrat en InP-n,
- la référence 95 représente une couche active,
- la référence 96 représente un réseau,
- la référence 97 représente une couche en InP-p,
- la référence 98 représente une couche de contact,
- les références 100 et 102 représentent des zones en matériau InP semi-isolant, placées de part et d'autre du ruban,
- la référence 103 représente une couche conductrice (du côté de la masse),
- les références 104, 105 et 106 représentent respectivement l'électrode de la section à 1,3 µm, l'électrode de la section absorbante et l'électrode de la section à 1,5 µm.

L'utilisation des sections absorbantes dans l'invention autorise l'utilisation d'une structure fondée sur le couplage bout à bout.

Pour fabriquer une telle structure, on peut utiliser la technique de l'épitaxie sélective en surface ou la technique de l'épitaxie localisée.

L'utilisation de ces techniques permet de réaliser des dispositifs conformes à l'invention correspondant sensiblement à celui qui est représenté sur la figure 1.

Dans ce cas, le couplage entre la section active à 1,5 µm et le guide à 1,3 µm est optimal et il en est de même pour le coefficient de détection à 1,5 µm.

La structure obtenue avec la technique de l'épitaxie localisée est schématiquement illustrée par la figure 6 où l'on voit un dispositif du genre de celui de la figure 1 mais comprenant une seule section absorbante 120 au lieu de deux telles sections, entre les sections 4 et 6.

La structure obtenue avec l'épitaxie sélective en surface est schématiquement illustrée par la figure 7 où l'on voit encore le même dispositif mais, dans le cas de la figure 7, une zone de transition 122 se trouve comprise entre la couche 12 et la couche 14.

L'épitaxie localisée (figure 6) consiste en une croissance localisée de matériaux.

Plus précisément, dans le cas de la figure 6, on procède de la façon suivante pour obtenir les couches placées bout à bout.

A partir d'une plaque composée par exemple des couches 14 et 2, la couche 14 correspondant à la couche 12 est enlevée. La croissance de la couche 12 est réalisée en masquant la couche 14.

L'épitaxie sélective en surface (figure 7) consiste à réaliser une croissance de matériaux dont l'énergie de bande interdite dépend de la forme géométrique et de la surface du masque utilisé pour la croissance de la couche 12.

Ceci permet d'obtenir une structure horizontale composée de plusieurs matériaux de bandes interdites différentes en une seule étape d'épitaxie.

Dans le cas de la figure 7, on procède de la façon suivante pour obtenir les couches placées bout à bout.

En plaçant une paire de masques de part et d'autre de l'endroit où la croissance du ruban sera effectuée, la croissance des couches 12 et 14 est simultanément réalisée.

Ces techniques d'épitaxie localisée et d'épitaxie sélective en surface contribuent d'une façon déterminante à la réalisation de dispositifs conformes à l'invention très performants.

En fonctionnement de type " full-duplex ", le laser à contre-réaction distribuée émettant à 1,3 µm est modulé.

Les sections absorbantes du dispositif comprenant ce laser doivent absorber la lumière modulée à haute fréquence.

Pour que l'absorption soit réellement efficace au cours d'une transmission, il faut que l'impédance (externe ou chargée) vue de la jonction de la section absorbante, soit suffisamment faible sur une bande de fréquences suffisamment large.

Une première technique pour obtenir ce résultat consiste à mettre des capacités au voisinage immédiat du dispositif intégré afin de diminuer l'impédance à haute fréquence.

Cependant, cette technique n'est efficace que si la résistance d'accès à la jonction est très faible.

Une technique préférable consiste à augmenter la capacité parasite de la jonction de chaque section absorbante par un élargissement du ruban de chaque section absorbante.

Ceci permet d'éviter une mise en place d'une ou de capacités additionnelles tout en supprimant une implication de la résistance d'accès à la jonction.

Ceci est schématiquement illustré par la figure 8 où l'on voit un dispositif conforme à l'invention comprenant une section absorbante 123 dans laquelle le ruban 124 de la section absorbante est plus large que dans les sections actives à 1,3 µm et 1,5 µm référencées 128 et 130, qui sont séparées par la section absorbante 123.

Sur la figure 8
- la référence 131 représente un substrat en InP-n,
- la référence 132 représente une couche en InP-p,
- la référence 133 représente une électrode,
- la référence 134 représente une électrode,
- la référence 135 représente une électrode,
- la référence 136 représente une électrode (masse),
- la référence 137 représente InP semi-isolant.

La figure 9 illustre de façon schématique une application de l'invention à la réalisation d'un duplexeur pour transmission bidirectionnelle en modulation d'intensité.

On voit sur la figure 9 une liaison bidirectionnelle en modulation d'intensité et en détection directe comportant deux dispositifs D1 et D2 conformes à l'invention.

Ces dispositifs D1 et D2 sont disposés de manière à pouvoir effectuer des échanges d'informations à 1,3 µm du dispositif D1 vers le dispositif D2 et à 1,5 µm du dispositif D2 vers le dispositif D1, par l'intermédiaire d'une fibre optique 140.

On voit, pour chacun des dispositifs D1 et D2, la section S13 à 1,3 µm, la section S15 à 1,5 µm et une section intermédiaire SI placée entre les sections S13 et S15 et polarisée en inverse par des moyens appropriés 142.

Dans le dispositif D1, l'émission d'un signal est réalisée avec la section S13 au moyen d'un générateur G1.

La section S15 du dispositif D1 fonctionne comme une photodiode.

Le dispositif D2 est disposé d'une façon complémentaire au dispositif D1.

Dans ce dispositif D2, l'émission d'un signal est réalisée avec la section S15 au moyen d'un générateur G2.

Le signal de longueur d'onde 1,3 µm provenant du dispositif D1, est détecté avec la section S13 qui fonctionne comme une photodiode.

Comme on le voit sur la figure 9, des amplificateurs de haute fréquence A1 et A2, dont sont respectivement munis les dispositifs D1 et D2, permettent d'améliorer la sensibilité de détection.

Une réduction de la diaphonie peut être envisagée par la soustraction des perturbations provenant des émetteurs, en utilisant des amplificateurs différentiels AD1 et AD2 respectivement à la place des amplificateurs A1 et A2.

La configuration de la figure 9 fonctionne aussi bien en mode émission-réception simultanées qu'en mode alternat.

La figure 10 illustre de façon schématique une autre application de l'invention à la réalisation d'un récepteur de signaux optiques à 1,3 µm et à 1,55 µm de façon simultanée et avec démultiplexage de ces signaux.

Ce récepteur comprend un dispositif conforme à l'invention D comprenant une section S13 active à 1,3 µm, une section S155 active à 1,55 µm et une section intermédiaire SI placée entre ces sections S13 et S155 et polarisée de façon inverse par des moyens appropriés 156.

On polarise en inverse les sections S13 et S155 ou on leur applique une polarisation nulle.

On peut ainsi détecter les signaux multiplexés en longueur d'onde à 1,3 µm et à 1,55 µm à partir de ces sections S13 et S155.

Le signal à 1,3 µm est détecté avec la section S13 et le signal à 1,55 µm est détecté avec la section S155.

Des amplificateurs de haute fréquence A3 et A4 respectivement associés à des tés de polarisation T1 et T2 peuvent être utilisés pour améliorer la sensibilité du dispositif de la figure 10.

Les références 158 et 160 représentent des moyens de polarisation en inverse des sections S13 et S155.

Une autre application de l'invention est schématiquement illustrée par la figure 11 qui représente un émetteur de signaux optiques multiplexés à 1,3 µm et à 1,5 µm, modulés en intensité ou codés par changement de fréquence.

On voit encore les deux sections S13 et S15 du dispositif D3 conforme à l'invention que comprend cet émetteur, ces sections étant séparées par une section intermédiaire SI polarisée en inverse par des moyens appropriés, non représentés.

La section S13 est commandée par un générateur G3 pour émettre des signaux à 1,3 µm tandis que la section S15 est commandée par un générateur G4 pour émettre des signaux à 1,5 µm.

On dispose ainsi de deux lasers à contre-réaction distribuée à 1,3 µm et à 1,5 µm.

On est capable d'émettre des signaux modulés en intensité ou codés par changement de fréquence qui sont multiplexés en longueur d'onde.

La figure 12 illustre schématiquement une autre application de l'invention à l'obtention d'un récepteur, de façon simultanée, de signaux à 1,3 µm et à 1,5 µm codés par changement de fréquence.

Ce récepteur comprend un dispositif conforme à l'invention D4 dans lequel on trouve une section S13 à 1,3 µm, une section S15 à 1,5 µm et deux sections SI1 et SI2 placées entre ces sections S13 et S15 et polarisées en inverse.

La section S13 est munie d'un té de polarisation T3 associé à une source de courant C1.

La section S15 est munie d'un té de polarisation T4 associé à une source de courant C2.

Les sections intermédiaires SI1 et SI2 sont polarisées de façon négative par des moyens non représentés.

Dans le cas de la figure 12, les sections S13 et S15 constituent deux lasers à contre-réaction distribuée à 1,3 µm et 1,5 µm qui sont légèrement polarisés sous le seuil.

Or, un laser à contre-réaction distribuée polarisé sous le seuil (amplificateur) est capable d'effectuer une réception d'un signal codé par changement de fréquence.

On consultera à ce sujet le document (4).

Une amplification sélective en longueur d'onde, effectuée par un amplificateur à contre-réaction distribuée, permet de sélectionner l'un des deux états d'un signal codé par changement de fréquence (0 ou 1).

Ceci s'applique aisément à un dispositif conforme à l'invention fonctionnant avec deux longueurs d'onde.

Les signaux s13 et s15 à 1,3 µm et à 1,5 µm, codés par changement de fréquence, peuvent être extraits des sections S13 et S15 polarisées sous le seuil.

Un autre mode de fonctionnement de la réception à 1,3 µm consiste à détecter le signal s13 à partir d'une section absorbante (SI1 dans l'exemple représenté), polarisée en inverse.

On voit sur la figure 12 cette section SI1 munie d'un té de polarisation T5 lui-même associé à des moyens de polarisation négative 170.

Dans ce cas, la section active à 1,3 µm polarisée sous le seuil sert d'amplificateur sélectif.

Les documents cités dans la présente description sont les suivants :
(1) P.J. Williams, R.G. Walker, P.M. Charles, R. Ogden, R.H. Lord, F.A. Randle, G.M. Foster, I. Bennion and A.C. Carter, " Design and fabrication of transceiver modules featuring monolithic optoelectronic integrated circuits for TPON/BPON access networks ", OFC'91, San Jose (USA), paper PD11-1, 1991
(2) T.L. Koch and U. Koren, " Semiconductor photonic integrated circuits ", IEEE J. Quantum Electron., 27, pp.641-653 (1991)
(3) J. Charil, S. Slempkes, D. Robein, C. Kazmierski and J.C. Bouley, " Extremely low threshold operation of 1.5 µm GaInAsP/InP buried ridge stripe lasers ", Electron. Lett. 25, pp.1477-1479 (1989)
(4) R. Hui, N. Caponio, p. Gambini, M. Puleo and E. Vezzoni, " DFB active filter/detector for multichannel FSK optical transmission ", Electron. Lett., 27, pp.2016-2018 (1991).

## Revendications

1. Dispositif semiconducteur d'émission-réception à deux longueurs d'onde λ1 et λ2, ce dispositif étant **caractérisé en ce qu'**il comprend un substrat semiconducteur sur lequel sont intégrés de façon monolithique :
- un premier composant semiconducteur (4, 51) ayant une couche active à la longueur d'onde λ1, ce premier composant étant apte à émettre une lumière de longueur d'onde λ1 ou à détecter cette lumière de longueur d'onde λ1 suivant que ce premier composant est polarisé de façon directe ou inverse,
- un deuxième composant semiconducteur (6, 52) ayant une couche active à la longueur d'onde λ2, ce deuxième composant étant apte à émettre une lumière de longueur d'onde λ2 ou à détecter cette lumière de longueur d'onde λ2 suivant que ce deuxième composant est polarisé de façon directe ou inverse, les couches actives respectives des premier et deuxième composants étant alignées suivant la ligne de propagation des lumières,
- au moins un composant semi-conducteur intermédiaire (8, 10; 54; 90, 91, 92, 93) qui sépare les premier et deuxième composants l'un de l'autre et qui est apte à absorber la lumière de longueur d'onde λ1 sans absorber la lumière de longueur d'onde λ2, lorsqu'il est polarisé de façon inverse, et
- des moyens (46, 48 ; 156) de polarisation de chaque composant intermédiaire de façon inverse.

2. Dispositif selon la revendication 1, **caractérisé en ce que** la couche active (12) du premier composant se prolonge dans chaque composant intermédiaire et **en ce que** chaque composant intermédiaire comprend une couche active à la longueur d'onde λ1 qui est constituée par un prolongement de la couche active du premier composant.

3. Dispositif selon l'une quelconque des revendications 1 et 2, **caractérisé en ce que** les premier et deuxième composants sont des composants à réseau de Bragg distribué (4, 6).

4. Dispositif selon l'une quelconque des revendications 1 et 2, **caractérisé en ce que** le premier composant est un composant à réseau de Bragg distribué (51) et **en ce que** le deuxième composant est un composant à cavité de Fabry-Pérot (52).

5. Dispositif selon l'une quelconque des revendications 1 à 4, **caractérisé en ce qu'**il comprend une pluralité de composants semiconducteurs intermédiaires (90, 91, 92, 93).

6. Dispositif selon l'une quelconque des revendications 1 à 5, **caractérisé en ce que** chacun des premier composant, deuxième composant et composant intermédiaire comprend une couche active à ruban, ce ruban étant bordé par des zones (100, 102) en un matériau semi-isolant.

7. Dispositif selon l'une quelconque des revendications 1 à 6, **caractérisé en ce que** le premier composant, le deuxième composant et chaque composant intermédiaire comprennent des couches actives (10, 12) placées bout à bout, obtenues par une technique d'épitaxie sélective en surface ou une technique d'épitaxie localisée.

8. Dispositif selon l'une quelconque des revendications 1 à 7, **caractérisé en ce que** en chacun des premier composant, deuxième composant et composant intermédiaire comprend une couche active à ruban, le ruban (124) de chaque couche intermédiaire étant plus large que ceux des premier et deuxième composants.

9. Dispositif selon l'une quelconque des revendications 1 à 8, **caractérisé en ce que** la longueur d'onde λ1 est inférieure à la longueur d'onde λ2.

10. Dispositif selon la revendication 9, **caractérisé en ce que** la longueur d'onde λ1 vaut 1,3 µm et **en ce que** la longueur d'onde λ2 vaut 1,5 µm.

11. Application du dispositif selon l'une quelconque des revendications 1 à 10 à la réalisation de duplexeurs pour transmission bidirectionnelle de signaux de longueurs d'onde λ1 et λ2, modulés en intensité, de récepteurs-démultiplexeurs de signaux de longueurs d'onde λ1 et λ2, d'émetteurs de signaux multiplexés de longueurs d'onde λ1 et λ2, respectivement modulés en intensité et codés par changement de fréquence, et de récepteurs de signaux de longueurs d'onde λ1 et λ2, codés par changement de fréquence.

## Patentansprüche

1. Sender/Empfänger-Halbleitervorrichtung mit zwei Wellenlängen λ1 und λ2, wobei diese Vorrichtung
**dadurch gekennzeichnet ist, dass** sie ein Halbieitersubstrat umfasst, auf dem monolithisch integriert sind:
- ein erstes Halbleiter-Bauelement (4, 51) mit einer aktiven Schicht der Wellenlänge λ1, wobei dieses erste Bauelement fähig ist, ein Licht der Wellenlänge λ1 zu emittieren oder dieses Licht der Wellenlänge λ1 zu detektieren, je nachdem, ob dieses erste Bauelement direkt oder invers polarisiert bzw. vorgespannt ist,
- ein zweites Halbleiter-Bauelement (6, 52) mit einer aktiven Schicht der Wellenlänge λ2, wobei dieses zweite Bauelement fähig ist, ein Licht der Wellenlänge λ2 zu emittieren oder dieses Licht der Wellenlänge λ2 zu detektieren, abhängig davon, ob dieses erste Bauelement direkt oder invers polarisiert bzw. vorgespannt ist,
wobei die jeweilige aktive Schicht des ersten und des zweiten Bauelements entsprechend der Ausbreitungsrichtung des Lichts ausgerichtet ist,
- wenigstens ein Halbleiter-Zwischenelement (8, 10; 54; 90, 91, 92, 93), welches das erste und zweite Bauelement voneinander trennt und das fähig ist, das Licht der Wellenlänge λ1 zu absorbieren ohne das Licht der Wellenlänge λ2 zu absorbieren, wenn es invers polarisiert bzw. vorgespannt ist, und
- Einrichtungen (46, 48; 156), um jedes Zwischenelement invers zu polarisieren bzw. vorzuspannen.

2. Vorrichtung nach Anspruch 1, **dadurch gekennzeichnet, dass** die aktive Schicht (12) des ersten Bauelements sich in jedes Zwischenelement verlängert, und dadurch, dass jedes Zwischenelement eine aktive Schicht der Wellenlänge λ1 umfasst, die gebildet wird durch eine Verlängerung der aktiven Schicht des ersten Bauelements.

3. Vorrichtung nach einem der Ansprüche 1 und 2, **dadurch gekennzeichnet, dass** das erste und das zweite Bauelement (4, 6) Bauelemente mit verteiltem Bragg-Gitter sind.

4. Vorrichtung nach einem der Ansprüche 1 und 2, **dadurch gekennzeichnet, dass** das erste Bauelement (51) ein Bauelement mit verteiltem Bragg-Gitter ist, und dadurch, dass das zweite Bauelement (52) ein Bauelement mit Fabry-Perot-Resonator ist.

5. Vorrichtung nach einem der Ansprüche 1 bis 4, **dadurch gekennzeichnet, dass** sie eine Vielzahl Halbleiter-Zwischenelemente (90, 91, 92, 93) umfasst.

6. Vorrichtung nach einem der Ansprüche 1 bis 5, **dadurch gekennzeichnet, dass** jedes der Elemente, nämlich erstes Bauelement, zweites Bauelement und Zwischenelement, eine aktive Streifenschicht umfasst, wobei dieser Streifen durch Zonen (100, 102) aus einem semi-isolierenden Material begrenzt wird.

7. Vorrichtung nach einem der Ansprüche 1 bis 6, **dadurch gekennzeichnet, dass** das erste Bauelement, das zweite Bauelement und jedes Zwischenelement aktive Schichten (10, 12) umfasst, aneinandergefügt angeordnet und hergestellt mittels einer selektiven Oberflächenepitaxietechnik oder einer lokalisierten Epitaxietechnik.

8. Vorrichtung nach einem der Ansprüche 1 bis 7,**dadurch gekennzeichnet, dass** jedes der Elements, nämlich erstes Bauelement, zweites Bauelement und Zwischenelement, eine aktive Streifenschicht umfasst, wobei der Streifen (124) jeder Zwischenschicht breiter ist als derjenige des ersten und zweiten Bauelements.

9. Vorrichtung nach einem der Ansprüche 1 bis 8, **dadurch gekennzeichnet, dass** die Wellenlänge λ1 kleiner ist als die Wellenlänge λ2.

10. Vorrichtung nach Anspruch 9, **dadurch gekennzeichnet, dass** die Wellenlänge λ1 1,3 µm beträgt, und dadurch, dass die Wellenlänge λ2 1,5 µm beträgt.

11. Anwendung der Vorrichtung nach einem der Ansprüche 1 bis 10 zur Realisierung von Duplexern für eine Zweirichtungs-Übertragung intensitätsmodulierter Signale der Wellenlängen λ1 und λ2, von Empfängern-Demultiplexern von Signalen der Wellenlängen λ1 und λ2, von Sendern multiplexierter Signale der Wellenlängen λ1 und λ2, jeweils intensitätsmoduliert und codiert durch Frequenzwechsel, und von Empfängern von Signalen der Wellenlängen λ1 und λ2, codiert durch Frequenzwechsel.

## Claims

1. Emitting/receiving semiconductor device for two wavelengths λ1 and λ2, this device being **characterised in that** it comprises a semiconductor substrate on which are monolithically integrated:
- a first semiconductor component (4, 51) having a layer active at the wavelength λ1, this first component being adapted to emit light of wavelength λ1 or to detect this light of wavelength λ1 according to whether this first component is polarised directly or inversely,
- a second semiconductor component (6, 52) having a layer active at wavelength λ2, this second component being adapted to emit light of wavelength λ2 or to detect this light of wavelength λ2 according to whether this second component is polarised directly or inversely, active layers of the first and second components respectively being aligned along the line of propagation of the light,
- at least one intermediate semiconductor component (8, 10; 54; 90, 91, 92, 93) which separates the first and second components from one another and which is adapted to absorb light of wavelength λ1 without absorbing light of wavelength λ2, when it is polarised inversely, and
- means (46, 48: 156) for polarising each intermediate component inversely.

2. Device according to Claim 1, **characterised in that** the active layer (12) of the first component is extended into each intermediate component and **in that** each intermediate component comprises a layer active at the wavelength λ1 which is constituted by an extension of the active layer of the first component.

3. Device according to Claims 1 and 2, **characterised in that** the first and second components are distributed Bragg grating components (4, 6).

4. Device according to either one of Claims 1 and 2, **characterised in that** the first component is a distributed Bragg grating component (51) and **in that** the second component is a Fabry-Pérot cavity component (52).

5. Device according to any one of Claims 1 to 4, **characterised in that** it comprises a plurality of intermediate semiconductor components (90, 91, 92, 93).

6. Device according to any one of Claims 1 to 5, **characterised in that** each of the first component, second component and intermediate component comprises a stripe active layer, this stripe being bounded by zones (100, 102) of a semi-insulating material.

7. Device according to any one of Claims 1 to 6, **characterised in that** the first component, the second component and each intermediate component comprise active layers (10, 12) placed end to end, obtained by a selective surface epitaxial technique or a localised epitaxial technique.

8. Device according to any one of Claims 1 to 7, **characterised in that** in each of the first component, second component and intermediate component comprises a stripe active layer, the stripe (124) of each intermediate layer being larger than those of the first and second components.

9. Device according to any one of Claims 1 to 8, **characterised in that** the wavelength λ1 is less than the wavelength λ2.

10. Device according to Claim 9, **characterised in that** the wavelength λ1 amounts to 1.3 *µ*m and **in that** the wavelength λ2 amounts to 1.5 *µ* m.

11. The application of the device according to any one of Claims 1 to 10 to the realisation of duplexers for bi-directional transmission of intensity-modulated signals of wavelengths λ1 and λ2, receivers/demultiplexers of signals of wavelengths λ1 and λ2, emitters of multiplexed signals of wavelengths λ1 and λ2, respectively intensity-modulated and coded by frequency-shifting, and receivers of signals of wavelengths λ1 and λ2, coded by frequency-shifting.
